# EUROPEAN PATENT SPECIFICATION

(11) **EP 2 450 741 B1**
(45) Date of publication and mention of the grant of the patent: **06.01.2021**
(21) Application number: 10189878.1
(22) Date of filing: 03.11.2010
(51) Int. Cl.: G02F 1/1335, G06F 3/041

(54) **DISPLAY DEVICES CONTAINING A CIRCULAR POLARIZING SYSTEM AND METHODS RELATED THERETO**
Anzeigevorrichtungen mit einem kreisförmigen polarisierenden System und zugehörige Verfahren
Dispositifs d'affichage contenant un système de polarisation circulaire et procédés associés à ceux-ci

(43) Date of publication of application: 09.05.2012
(73) Proprietor: BlackBerry Limited, Waterloo, ON N2K 0A7 (CA)
(72) Inventor: Fletcher, Bergen Albert, Waterloo Ontario N2L 3W8 (CA); Purdy, Michael Lorne, Waterloo Ontario N2L 3W8 (CA); Prieto, Glover Ruiz, Waterloo Ontario N2L 3W8 (CA); Robinson, James Alexander, Waterloo Ontario N2L 3W8 (CA)
(74) Representative: Hanna Moore + Curley

(56) References cited:
- WO-A1-2004/053580
- US-A1- 2004 069 985
- US-A1- 2008 150 901
- US-A1- 2008 297 685
- US-A1- 2009 066 862
- US-A1- 2009 237 602

## Description

### BACKGROUND

Mobile devices are becoming increasingly popular and are being used with an expanding number of applications. Consumers are further demanding improved device appearance, even when the mobile device is not in use.

A mobile device can use a variety of display technologies, including, but not limited to, a liquid crystal display (LCD), a light emitting diode (LED), an organic LED (OLEO), an active matrix OLEO (AMOLED), a cathode ray tube (CRT), a electro luminescent display, a vacuum fluorescent display or a micro electro-mechanical (MEM) display.

When a display on a display device (i.e., the active area of the display) is off, however, a reflection between the display and cover lens or from one or more elements located between the display and the cover lens, or both, is still visible when the active area does not substantially match the reflected intensity and color of the border of the cover lens. The inventors are the first to recognize a need to substantially match the active area in the off state with the lens border to create the appearance of a "hidden display."

International patent application publication number WO2004/053580 discloses a liquid crystal display device for suppressing a wavelength and viewing dependence in a dark state.

US patent application publication number US 2008/0297685 discloses an image display device having a configuration that allows the device to be manufactured in such a way as to prevent unwanted spread and penetration of the polymeric precursor of the elastomer in its liquid display panel.

US2004/069985 discloses a top emitting OLED display including: a substrate, an array of OLED light emissive elements formed over the substrate, an encapsulating cover located over the OLED light emissive elements, and a circular polarizer located between the encapsulating cover and the OLED light emissive elements.

An invention is set out in the appended claims.

### BRIEF DESCRIPTION OF THE DRAWINGS

FIG. 1 is an illustration of the operation of a circular polarizer.
FIG. 2 is an illustration of a polarizing system in a display device according to an example embodiment.
FIG. 3 is an illustration of an alternative polarizing system in a display device according to an example embodiment.
FIG. 4 is an illustration of another alternative polarizing system in a display device according to an example embodiment.
FIG. 5 is a block diagram according to an example embodiment.

### DETAILED DESCRIPTION

In the following description, numerous specific details are set forth in order to provide a thorough understanding of example embodiments. It is to be understood, however, that the various embodiments may be practiced without these specific details. For example, logical, electrical and structural changes may be made without departing from the spirit and scope of the present subject matter. The following detailed description is, therefore, not to be taken in a limiting sense, and the scope of embodiments is defined only by the appended claims.

Display devices containing circular polarizing systems and methods related thereto are described. Embodiments described herein are directed to energy-efficient display devices which have lens-covered displays configured to retain a uniform appearance across an on-state and an off-state. This result may be accomplished by securing a polarizing device to a back or inner side of the lens to reduce reflection between the display and the lens or a reflection off (i.e., from) one or more elements located between the display and the lens, or both, thus allowing an active area defined by a display border on the display (and having an active area color and active area luminance) to substantially match a color or reflected luminance (hereinafter "luminance") i.e., reflected intensity, or both, of a lens border when the active area or the entire device is in the off-state. In one embodiment, the display device is a transmissive display device. In one embodiment, the display device is an emissive display device.

In one embodiment, an apparatus comprising a display device having an active area; a lens device, wherein the lens device comprises a lens border having a lens border color; and a circular polarizer located proximate to the lens border, wherein the lens border color substantially matches an active area color of the active area of the display device is provided.

To date, attempts to "match" the active area in the off-state include adding paint to a border area of the lens, i.e., the lens border. The paint is chosen on the basis of having a similar color and luminance as the active area when in the off-state. However, since it is not possible to substantially match these features of the active area using only paint, the results have been disappointing. For example, oftentimes, a "painted" display device (i.e., a display device having a painted lens border), has a lens border which appears different in color (e.g., darker), has a different luminance, or both as compared to the color, luminance, or both, of the active area, when in the off-state.

In one embodiment, one or more circular polarizers are added to the display device to address this problem. Essentially, a circular polarizer (i.e., circular polarizing filter) modifies ambient light as it passes through, trapping the mirror image on reflection from a reflecting surface. In embodiments in which the display device emits a linearly polarized light or signal, this signal is allowed to pass through the circular polarizer, appearing to the user as a bright image against a dark background. In one embodiment, the circular polarizer is added to a bottom surface of a lens located on the outermost surface of the display device. In one embodiment, signal throughput efficiency is improved with use of a quarter wave retarder located on a top surface of the display to convert the linear polarized light. In one embodiment, the quarter wave retarder and linear polarizer are aligned with the circular polarizer on the lens to maximize signal throughput efficiency.

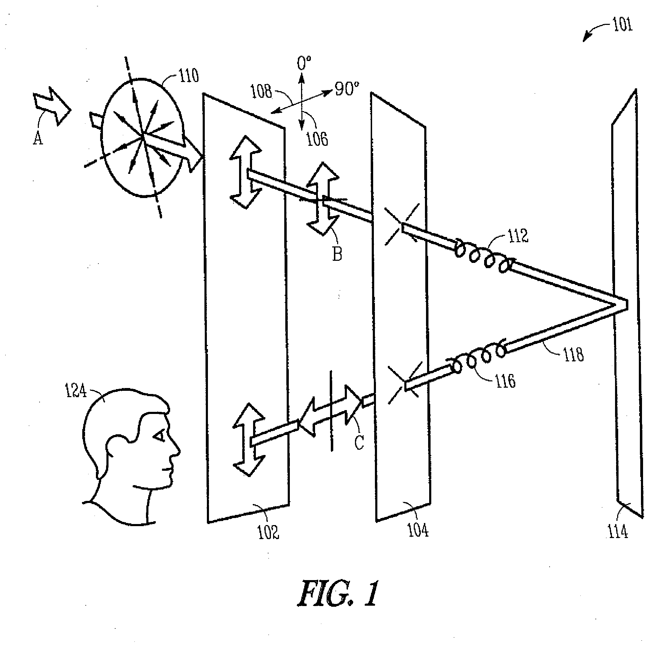

FIG. 1 illustrates the operation of a conventional circular polarizer 101 which comprises a linear polarizer 102 and a quarter wave retarder 104. The linear polarizer 102, in turn, is known to have a transmitting axis 106 and an absorbing axis 108. As described in U.S. Patent No. 5,326,968 to Johnson, et al, in a circular polarizer, unpolarized light 110, such as ambient light, passes in a direction symbolically represented by arrow "A" through the linear polarizer 102 and quarter wave retarder 104. As the unpolarized light 110 passes through the linear polarizer 102, it becomes polarized, with only the light which is aligned with the transmitting axis 106 permitted to pass through. This polarized linear light is symbolically represented by arrow "B" which is aligned in a predefined plane parallel to the transmitting axis 106, i.e., the light is polarized in the direction represented by arrow "B." Thereafter, the light passes through the quarter wave retarder 104, to result in polarized directional circular light, such as polarized right circular light 112. The quarter wave retarder has a fast and slow axis, which are perpendicular to one another. To generate circularly polarizer light, the transmitting axis 106 of the linear polarizer is aligned at 45 degrees to the fast and slow axes of the quarter wave retarder.

If the polarized right circular light 112 (i.e., "incident light") strikes an object, such as a reflecting surface 114, which does not result in a scattering of the polarized right circular light 112, the light will switch handedness, which, in the example shown in FIG. 1, causes the light to return as polarized left circular light 116 (i.e., "reflected light") along a line 118. The polarized left circular light 116 passes again through the quarter wave retarder 104, resulting in polarized linear light having a direction represented by arrow "C." Since this light is along the absorbing axis 108 of the linear polarizer 102, it cannot pass through the linear polarizer 102, and thus cannot be seen by a user 124.

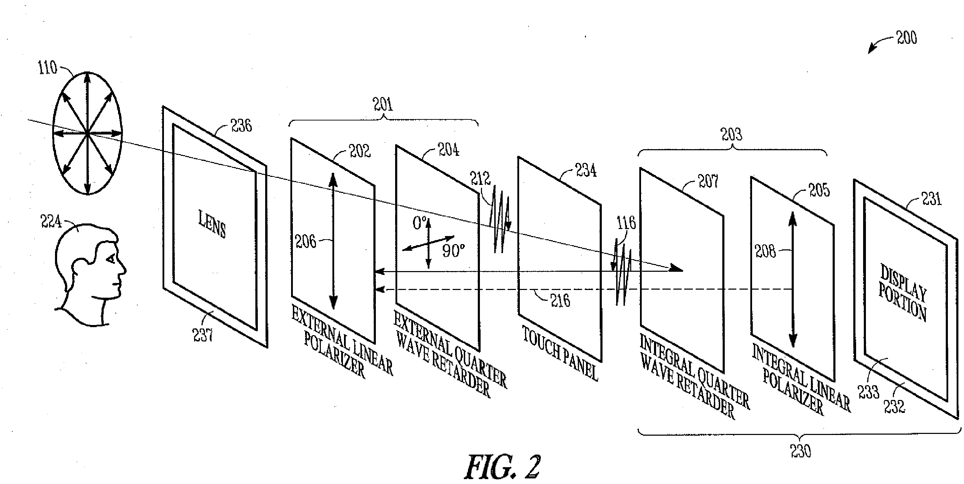

FIG. 2 illustrates a novel display device 200 comprising a display 230 having a display portion 231 with a display border 232 located along its perimeter to define an active area 233 therein. The display border 232 can comprise any suitable dimensions. In one embodiment, the display border 232 comprises no more, than about five (5) to 10% of the total surface area of the display portion 231, such as about two (2) to five (5) mm in width for a display portion 231 having a surface area of about 20 to 40mm². The active area 233 comprises an area in which data can be viewed by a user 224 in the form of text, icons, images, video, and the like, when the display device 200 is on, but can appear as a blank or substantially dark or uniform image when the display portion 231 or the entire display device 200 is off. The active area 233 can have an active area color and an active area luminance. In one embodiment, the display device 200 further has one or more elements located between the display 230 and a cover or lens 236, such as a touch panel 234, as shown in FIG. 2, which can substantially cover the active area 233.

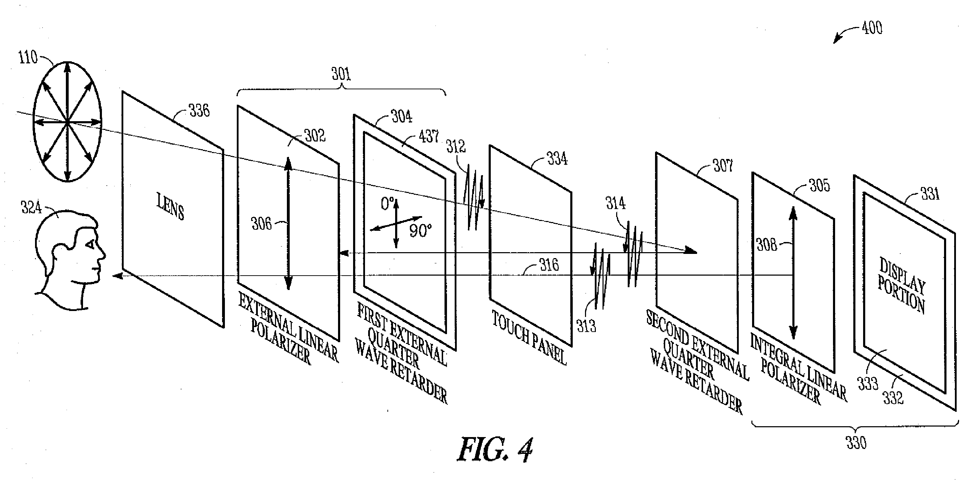

The lens 236 can have an outer surface, an inner surface, and a lens border 237 with a lens border color. In other embodiments, the lens border is not located on the lens 236 (i.e., is not in front of the circular polarizer), but is located on the circular polarizer (i.e., behind the circular polarizer). See, for example, FIG. 4.

In one embodiment the lens 236 is substantially aligned with and located external to display 230, thus providing a cover for the display device 200. In the embodiment shown in FIG. 2, a polarizer, such as a circular polarizer, is located external to the display 230 (hereinafter "external circular polarizer 201") and proximate to an inner surface of the lens 236. The external circular polarizer 201 can be integral with the inner surface of the lens 236 or added as a separate component, such as a film. In one embodiment, the external circular polarizer 201 is added to a front side of the touch panel 234, although such a configuration further removes the external circular polarizer 201 from an outer surface of the lens 236. The external circular polarizer 201 can also be located on the outer surface of the lens 236, although such a configuration may be less durable. The external circular polarizer 201 reduces reflection between the display 230 and the lens 236 or from one or more elements located between the display 230 and the lens 236, such as the touch panel 234, or both, thus allowing the active area 233 of the display 230 to substantially match the color, and in some embodiments, the luminance, of the lens border 237 when the display device 200 is off, while minimizing any adverse affect to the appearance of the active area 233 (i.e., display on-state optics) while the display device 200 is on. In this way, a more uniform appearance is provided on the display device 200 when in an off state, as compared with a conventional display device having no external circular polarizer.

In one embodiment, there is no touch panel 234. In one embodiment, the one or more elements are selected from a touch panel 234, an air gap, adhesive/glue (optically clear), a transparent conductor such as indium tin oxide (ITO), lamination material, one or more metal jumpers, or any combination thereof.

In use, unpolarized ambient light 110 enters the display device 200 through the lens 236 and upon reaching the back surface of the lens 236, simultaneously or subsequently passes through the external circular polarizer 201, first passing through an external linear polarizer 202 and an external quarter wave retarder 204. The external linear polarizer 202 polarizes the light 110, allowing only the portion of the light aligned with its transmitting axis, i.e., external linear polarizer transmitting axis 206, to pass through, as shown in FIG. 1.

Thereafter, the light passes through the external quarter wave retarder 204 which converts the linearly polarized light into right or left hand circularly polarized determined by the orientation of a "fast axis" (i.e., "long axis of the wavefront ellipsoid, as understood in the art) of the external quarter wave retarder 204 to the external transmitting axis 206 of the external linear polarizer 202. For exemplary purposes only, in the embodiment in FIG. 2, the light exiting the external quarter wave retarder 204 is polarized left circular light 212.

In the embodiment shown in FIG. 2, the polarized left circular light 212 then passes through the touch panel 234 and reaches the display 230. In this embodiment, the display 230, which includes the display portion 231 and an internal polarizer 203, comprises an integral linear polarizer 205 and an integral quarter wave. retarder 207. In one embodiment, the integral quarter wave retarder 207 emits circularly polarized light. In one embodiment, the integral quarter wave retarder 207 emits elliptically polarized light.

A portion of the light can reflect off a front surface of the display portion 231 or a front surface of the one or more elements, such as the touch panel 234, or both, and travel or pass back (outwardly towards the user 224) through the integral linear polarizer 205. In one embodiment, however, most of the light, is reflected off a top surface of the integral quarter wave retarder 207 due to, for example, an air gap (not shown), such as between the touch panel 234 and the integral quarter wave retarder 207. The integral quarter wave retarder 207 causes light reflecting off its top surface, i.e., reflected light 212, to switch handedness. As a result, the reflected light 212 cannot pass through the external quarter wave retarder 204. Therefore, this reflected light 212 also does not transmit through the external linear polarizer 201 to the user 224. Light exiting the integral linear polarizer 205 is aligned with a display transmitting axis 208, which itself is aligned with the external linear polarizer transmitting axis 206 as shown by line 216, in order to reduce or minimize transmittance loss. In one embodiment, this loss is no more than about 15%.

In the embodiment shown in FIG. 2, the external circular polarizer 201 does not cover the entire lens 236, i.e., inner or back surface of the lens 236. Instead, the external circular polarizer 201 covers a portion of the inner surface of the lens 236 within the lens border 237, which defines an outer area of the lens, which is an area of substantially the same size as the active area 233 of the display portion 231. As a result, a line between the lens border 237 and the active area 233 may still be discernable when the display device 200 is in an off state, e.g., the active area 233 may appear to be grayer in color than the lens border 237 when the device is in an off state.

In order to minimize this appearance, the lens border 237 can be any suitable color adapted to substantially match the appearance of the active area 233 when in the off state. In one embodiment, the active area 233 substantially matches the color of the lens border 237. In one embodiment, the active area 233 also matches the luminance of the lens border 237. In one embodiment, the lens border 237, and, optionally, the display border 232, are provided with a dark color, such as a substantially black, gray, or black-gray color. This dark color can be provided via any suitable means known in the art, including, but not limited to, silk-screening, inking or painting. In one embodiment, the dark color is providing on both sides of the lens border 237.

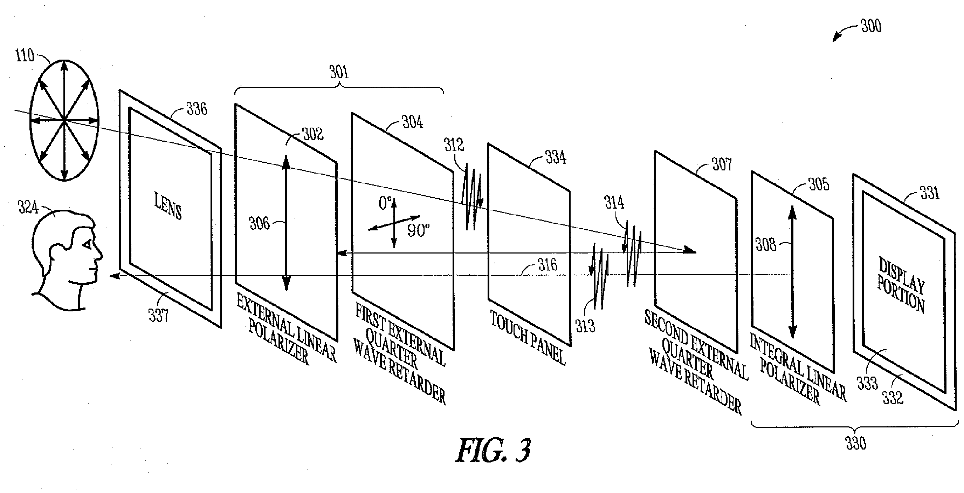

In an alternative embodiment, as shown in FIG. 3, the novel display device 300 comprises a display 330 (which emits linear light) with a display border 332 located along its perimeter to define an active area 333 therein. In this embodiment, a polarizer, such as an external circular polarizer 301 (which can be integral with the inner surface of the lens 236 or added as a separate component, such as a film), covers the entire inner surface of a lens 336. In this way, the color and luminance match between the lens border and the active area, when the device is in the off-state, is improved.

As noted above, the external circular polarizer 301 can also be added to a front surface of the touch panel 334. The lens 336 can be substantially aligned with and located external to the display 230, thus providing a cover for the display device 300. In this way, not only can a lens border 337 on the lens 336 substantially match the color, and in some embodiments, the luminance, of an active area 333 defined by the display border 332, since there is no discernable line between the active area 333 and the lens border 337, a substantially seamless appearance can now be provided to a user 324 across the active area 333 and the lens border 337, when the display device 300 is in an off state. Such a configuration further reduces or minimizes the impact of transmitted light being emitted from a display device 300 and has minimal, if any, adverse affect to display on-state optics. As with the lens border 237 described above, the lens border 337 can comprise a silk-screened border or an inked border or a painted border, such as a substantially black-colored border located on one or both sides of the lens border 237.

In the embodiment shown in FIG. 3, the display device 300 further has one or more elements located between the display 330 and a cover or lens 336, such as a touch panel 334, which can substantially cover the active area 333. The display border 332 can comprise any suitable dimensions and encompass any suitable percentage of the total surface area of the display portion 331 as described above for FIG. 2, and the active area 333 has the same features as described above.

In contrast to the embodiment shown in FIG. 2, however, in this embodiment, the display portion 330 can emit linear polarized light from an integral linear polarizer 305 through an integral transmitting axis 308. Therefore, in the embodiment shown in FIG. 3, the display device 300 further comprises a second quarter wave retarder 307 to ensure most (e.g., at least about 85 %) of the light leaving the display 330 is circularly polarized. In this way, any light passing through the lens 336 appears to the user 324 as a bright image against a dark background. As a result, and as noted above, the active area 333 and lens border 337 can appear substantially identical in color or luminance or both, thus creating a desirable seamless appearance on the display 330, which can be most noticeable when the display device 300 is in an off state.

In one embodiment, the lens border (e.g., lens border paint) is located on a bottom (i.e., back) side of the circular polarizer. See, for example, FIG. 4, which shows a display device 400 having a lens border 437 located on the back side of the first external quarter wave retarder 304.

In use, unpolarized ambient light 110 enters the display device 300 through the lens 336 and upon reaching the back surface of the lens 236, simultaneously or subsequently passing through the external circular polarizer 301, passing first through the external linear polarizer 302 and then the first external quarter wave retarder 304. The external linear polarizer 302 polarizes the light 110, allowing only the portion of the light aligned with its transmitting axis, i.e., external linear polarizer transmitting axis 306, to pass through, as shown in FIG. 3.

Thereafter, the light passes through the first external quarter wave retarder 304, where it is rotated by 45 degrees to result in polarized left or right circular light, as shown and described in FIG. 2. For exemplary purposes only, in the embodiment shown in FIG. 3, the light exiting the first external quarter wave retarder 304 is polarized left circular light 312. The polarized left circular light 312 then passes through the touch panel 334 and, upon being reflected from a front surface of the display 330 or a front surface of one or more elements located between the display 330 and the second external quarter wave retarder 307, or both, passes through the second external quarter wave retarder 307 where it is rotated in the opposite direction to produce, in this embodiment, polarized right circular light 313 which cannot travel or pass back (outwardly towards the user 324) through the external linear polarizer 302. In this embodiment, the display 330 includes only the display portion 331 and the integral linear polarizer 305. As such, the display 330 contains no integral quarter wave retarder (such as the integral quarter wave retarder 207 shown in FIG. 2).

Polarized linear light 316 emitted by the display 330 is also polarized in the second external quarter wave retarder 307 to ensure light leaving the display 330 (in the direction of the user 324) is circularly polarized. For exemplary purposes only, in the embodiment shown in FIG. 3, the light exiting the second external quarter wave retarder 307 is polarized left circular light 314, which is transmitted through the lens 336, as shown in FIG. 3. In one embodiment, the external transmitting axis 306 and the display transmitting axis 308 are substantially aligned for maximum light transmission. In one embodiment, more than 85% of the light is transmitted through the lens 336.

In one embodiment, a display device comprises a lens device, wherein the lens device comprises a lens border defining an outer area of a lens, the lens border having a lens border color; and a circular polarizer located proximate to the lens border, wherein the lens border color substantially matches an active area color of an active area located on the display device is provided. In this embodiment, the lens device is formed from the circular polarizer. In one embodiment, the display device further comprises a lens located external to the display. In one embodiment the lens border is located between the lens element and the circular polarizer. In one embodiment the lens border is located underneath the circular polarizer.

The circular polarizer (201, 301) can be made from any suitable material, such as glass or acrylics, as well as plastic film. The circular polarizer (201, 301) can further be a laminate or film made from any of these or other suitable materials.

The circular polarizer (201, 301) can be of any suitable thickness and further have any suitable shape, such as a shape which conforms with the shape of the device to which it is secured or applied. In one embodiment, the circular polarizer (201, 301) is at least about 0.1mm thick. In one embodiment, the circular polarizer (201, 301) is between about 0.1 mm and about 0.3 mm in thickness, including any range there between, or between about 0.1 mm and about 0.15 mm, including any range there between.

The lens (236, 336) or the circular polarizer (201, 301), or both, can each optionally further have a non-glare surface finish or an anti-reflective surface finish, which can be useful when the device is being used in sunlight. In one embodiment, the circular polarizer (201, 301) is neutral in color. In one embodiment, the quarter wave retarder (i.e., retarder element, such as 204, 207, 304) provides a substantially constant retardation across the visible spectrum (optimized for λ/4 at 555nm, but maintained as close to λ/4 as possible from 390nm to 750nm).

The circular polarizer (201, 301) can be made by any standard methods known in the art, such as a dry film lamination process. The circular polarizer (201, 301) can have any suitable polarizing efficiency and single unit transmission. In one embodiment, the polarizing efficiency or the single unit transmission, or both, is maximized. In one embodiment, the circular polarizer (201, 301) has a polarizing efficiency ≥ 99% and a single unit transmission greater than about 43%. The circular polarizer (201, 301) can further have any suitable durability, i.e., temperature and humidity tolerances, depending on the particular application. In one embodiment, the circular polarizer (201, 301) can withstand high temperatures, such as up to about 27 °C (about 80.6°F) or higher, such as up to 43°C (109.4 °F), and high humidity conditions, such as up to 95% or greater, including up to 100% humidity.

In one embodiment, the distance between the circular polarizer 110 and the outer surface of the lens (236, 336), i.e., the thickness of the lens, is no greater than about 0.5 mm. In one embodiment, the thickness is between about 0.2 up to less than one (1) mm, although, in some embodiments, the thickness of the lens (236, 336), may be as high as 1.5 mm, including any ranges there between.

In one embodiment, the thickness from a top surface of the display portion (231, 331), plus the thickness of any lamination material (such as optically clear adhesive (OCA), plus the thickness of a touch panel (if present), together with the thickness of an air gap (e.g., located between the touch panel and the display) plus the thickness of an outer cover, such as a lens (e.g., ∼0.5 mm) (236, 336) can be within a range of about one (1) to about 1.5 mm thick.

In contrast to conventional prior art devices having a circular polarizer located within, or used as a top layer of, a display, such that the circular polarizer is at least about one (1) mm away from the outer surface of the lens, the novel devices described herein minimize this distance by locating the circular polarizer (201, 301) immediately adjacent to, or integral with, an inner surface of the outer covering (e.g., lens 236, 336). Therefore, any reflections between the display portion (231,331) and the lens (236, 336), or from any of the one or more elements located between the display portion (231, 331) and the lens (236, 336) is minimized. Additionally, although such conventional devices may reduce reflection between metal layers present in a display (e.g., in an active matrix organic light emitting diode), they do not solve the problems being addressed herein, which includes reducing the reflections between the display and cover lens, from any of the one or more elements located between the display and cover lens, or both.

The novel display devices described herein can be combined with any product having a lens with or without a touch panel. The display device, in some embodiments, can be a portion, part, or component of a broader system or assembly, including a camera device or any type of mobile wireless device, including, but not limited to, mobile telephones, portable computers, personal digital assistants (PDAs), "smart" phones, global positioning system (GPS) device and other devices that may be conveniently carried by a user and provide wireless communication. Mobile telephones include wireless communication devices that have generally been referred to as cell phones. Mobile telephones may include a wide range of communication devices from portable phones with limited functionality beyond voice communication to portable phones capable of providing the functionality of a personal computer. A personal computer (PC) herein refers to computing devices having an operating system (OS) such that use of the personal computer may be conducted by individuals having little or no knowledge of the basics of the underlying hardware and software that operate the PC and whose operation may be conducted without individuals typically authoring computer programs to operate the computer. Portable computers may include portable personal computers (PCs). An example of a portable PC is a laptop computer or notebook computer that typically has a display screen, keyboard, underlying hardware and software, and a display pointing device that are all integrated in a housing that can easily be carried by an individual. Some PDAs may be viewed as a type of portable computer.

The display device is capable of receiving image information to be displayed, such as a mobile code image. The mobile code image can be received in several ways, such as from a camera or via a web page, email, a picture-based message, or other electronic modes depending on the capabilities of the mobile electronic device. The mobile code image is received by an application executing on the mobile electronic device and resolved to obtain the dataset. The data from the dataset is then parsed or otherwise processed by the application to obtain the content and additional content identifier. The content item can then be presented along with a representation of the additional content item identifier. The representation of the additional content item identifier can be content-retrieved from a network location, such as a location in the database via a server identified by the additional content item identifier, a user interface control that can be selected by a user to trigger downloading of the additional content based on the additional content item identifier, or other representation. Although the dataset may include renderable content, such as an image, text, graphic, audio, or other content, embodiments described herein are generally pertinent to renderable visible content (e.g., image, text, graphic, and the like). The dataset can also include an identifier of additional content.

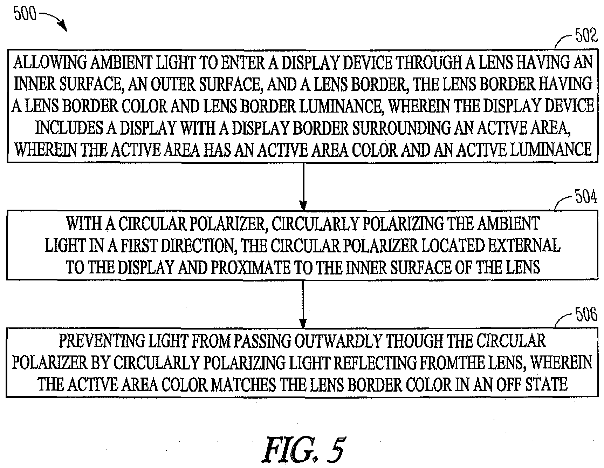

FIG. 5 is a block flow diagram of a method 500 according to an example embodiment. The method 500 is an example of a method that can be performed in whole, or in part, by a device display. Such a display device can include at least one processor, at least one memory device, a network interface device, and a user interface.

The example method 500 includes, in one embodiment, allowing 502 ambient light to enter a display device through a lens having an inner surface, an outer surface, and a lens border, the lens border having a lens border color and lens border luminance, wherein the display has a display border surrounding an active area having an active area color and an active area luminance. The method continues by thereafter, with a circular polarizer, circularly polarizing 504 the ambient light in a first direction, the circular polarizer located external to the display and proximate to the inner surface of the lens. The method continues by preventing 506 light from passing outwardly through the circular polarizer by circularly polarizing light reflecting from the lens, wherein the active area color matches the lens border color in an off state. In one embodiment, the method prevents the light from passing outwardly through the circular polarizer by circularly polarizing light reflecting from one or more elements located between the display and the lens. This result occurs because the ambient light becomes circularly polarized after passing through the circular polarizer, and, upon reflecting off the one or more elements, changes direction, thus becoming unable to pass back through the circular polarizer.

The method can further include, for embodiments in which the display emits linearly polarized light (rather than circularly polarized light), circularly polarizing light leaving the display with a second quarter wave retarder located between the circular polarizer and the display.

In one embodiment, a method comprising allowing ambient light to enter an apparatus comprising a display device having an active area and a lens device, wherein the lens device has a lens border with a lens border color; with a circular polarizer, circularly polarizing the ambient light in a first direction, the circular polarizer located proximate to the lens border, and preventing light from passing outwardly through the circular polarizer by circularly polarizing light reflecting from the lens device, wherein the lens border color substantially matches an active area color of an active area located on the display device is provided.

Embodiments described herein provide, for the first time, the ability to reduce reflection between a lens and a display, from one or more elements located between the lens and the display, or both, through use of an external circular polarizer applied to a covering lens, rather than to a display located under the lens. Various embodiments further allow, for the first time, the ability to provide a display which has the same borderless appearance across on and off states, through inclusion of a second quarter wave retarder on top of the display.

Method examples described herein can be machine or computer-implemented, at least in part. Some examples can include a computer-readable medium or machine-readable medium encoded with instructions operable to configure an electronic device to perform methods as described in the above examples. An implementation of such methods can include code, such as microcode, assembly language code, a higher-level language code, or the like. Such code can include computer readable instructions for performing various methods. The code may form portions of computer program products. Further, the code may be tangibly stored on one or more volatile or non-volatile computer-readable media during execution or at other times. These computer-readable media may include, but are not limited to, hard disks, removable magnetic disks, removable optical disks (e.g., compact disks and digital video disks), magnetic cassettes, memory cards or sticks, random access memories (RAMs), read only memories (ROMs), and the like.

Although specific embodiments have been illustrated and described herein, it will be appreciated by those of ordinary skill in the art that any procedure that is calculated to achieve the same purpose may be substituted for the specific embodiments shown. This application is intended to cover any adaptations or variations of the present subject matter. For example, although the various embodiments have been described in terms of one or more circular polarizers, it is also possible to use one or more elliptical polarizers. Therefore, it is manifestly intended that embodiments described herein be limited only by the claims.

## Claims

1. An apparatus comprising:
a display device (200, 300, 400) having an active area (233, 333) and an integral linear polarizer (205, 305) located over the active area (233, 333);
a quarter wave retarder (207, 307) located over the integral I linear polarizer (205, 305); and
a lens device comprising:
a lens (236, 336) substantially aligned with and located external to the display (230, 330),
a lens border (237, 337, 437) having a lens border color substantially matching an active area color of the active area (233, 333) of the display device (200, 300, 400) when the display device (200, 300, 400) is off, and
a circular polarizer (201, 301) located proximate to the lens border (237, 337, 437) between the lens (236, 336) and the quarter wave retarder (207, 307), the circular polarizer (201, 301) being substantially aligned with the display device (200, 300, 400);
wherein the circular polarizer (201, 301) is configured to circularly polarize, in a first direction, ambient light entering the apparatus, and to prevent light, circularly polarized in a second direction opposed to the first direction, from passing outwardly through the circular polarizer (201, 301), and
wherein the quarter wave retarder (207, 307) is configured to circularly polarize, according to said first direction, display light emitted from the integral linear polarizer (205, 305).

2. The apparatus of claim 1 wherein the active area (233, 333) of the display device (200, 300, 400) has an active area luminance and the lens border (237, 337, 437) has a lens border luminance which substantially matches the active area luminance.

3. The apparatus of claim 1 wherein the lens border (237, 337, 437) is located between the lens (236, 336) and the circular polarizer (201, 301).

4. The apparatus of claim 1 wherein the lens border is located between the circular polarizer (201, 301) and the quarter wave retarder (207, 307).

5. The apparatus of claim 3 wherein the circular polarizer (301) is secured to an inner surface of the lens (336) or is integral with the inner surface of the lens (336), and wherein the lens border (437) is located on an inner surface of the circular polarizer (301).

6. The apparatus of claim 3 wherein the display (230, 330) has a display border (232, 332) which defines the active area (233, 333) of the display device (200, 300, 400), and wherein the apparatus further comprises a touch panel (234, 334) located between the quarter wave retarder (207, 307) and the circular polarizer (201,301).

7. The apparatus of any of claims 1 to 6 wherein the lens border (237, 337, 437) is a silk-screened border, an inked border or a painted border located on the lens (236, 336) or the circular polarizer (201,301), wherein the display (230, 330) is a liquid crystal display, LCD, a light emitting diode, LED, an organic LED,OLED, an active matrix OLED, AMOLED, cathode ray tube, CRT, electro luminescent display, a vacuum fluorescent display or a micro electro-mechanical, MEM, display, and wherein the display device (200, 300, 400) is a transmissive display device or an emissive display device.

8. The apparatus of claim 1, wherein said quarter wave retarder is an integral quarter wave retarder (207) of the display (230).

9. The apparatus of claim 1, wherein said quarter waver retarder is located external to the display (330).

10. The apparatus of claim 1, wherein said circular polarizer (201, 301) comprises a second quarter wave retarder (204, 304) and a second linear polarizer (202, 302) located between said lens (236, 336) and the second quarter wave retarder (204, 304), wherein the second linear polarizer (202, 302) defines a light transmitting axis (206, 306) allowing light to pass through the second linear polarizer (202, 302), and wherein the integral linear polarizer (205, 305) of the display (230, 330) is configured to emit display light aligned with a display transmitting axis (208, 308), the display transmitting axis (208, 308) being substantially aligned with the light transmitting axis (206, 306) of the second linear polarizer (202, 302).

11. A mobile device comprising an apparatus according to any of the preceding claims.

12. A method (500) comprising:
allowing (502) ambient light to enter an apparatus, the apparatus comprising:
a display device (200,300, 400) having an active area (233, 333) and an integral linear polarizer (205, 305) located over the active area (233, 333);
a quarter wave retarder (207, 307) located over the integral I linear polarizer (205, 305); and
a lens device comprising:
a lens (236, 336) substantially aligned with and located external to the display (230, 330),
a lens border (237, 337, 437) having a lens border color matching an active area color of the active area (233, 333) of the display device (200, 300, 400) when the display device (200, 300, 400) is off, and
a circular polarizer (201, 301) located proximate to the lens border (237, 337, 437) between the lens (236, 336) and the quarter wave retarder (207, 307), the circular polarizer (201, 301) being substantially aligned with the display device (200, 300, 400);
circularly polarizing (504), in a first direction, the ambient light with the circular polarizer (201, 301);
preventing (506) reflected portions of the circularly polarized ambient light from passing outwardly through the circular polarizer (201,301);
circularly polarizing, according to said first direction, display light emitted from integral linear polarizer (205, 305) with the quarter wave retarder (207, 307); and
allowing the circularly polarized light emitted from the integral linear polarizer (205, 305) to pass outwardly through the circular polarizer (201, 301).

13. The method of claim 12 wherein the reflected ambient light is circularly polarized in a second direction opposite to said first direction, and wherein the lens border (237, 337, 437) is located between the lens (236, 336) and the circular polarizer (201,301) or between the circular polarizer (201,301) and the quarter wave retarder (207, 307).

14. The method of claim 12 wherein the circular polarizer (201,301) is located between the lens (236, 336) and the lens border (237, 337, 437).

15. The method of claim 12 wherein the active area color and active area luminance substantially match the lens border color and lens border luminance to provide the lens border (337) and active area (333) with a substantially uniform appearance, wherein a touch panel (234, 334) is located between the quarter wave retarder (207, 307) and the circular polarizer (201,301), and wherein said reflected portions of the circularly polarized ambient light that are prevented from passing outwardly through the lens (236, 336) with the circular polarizer (201,301) comprise ambient light reflected from the touch panel (234, 334).

## Patentansprüche

1. Gerät, umfassend:
eine Display-Vorrichtung (200, 300, 400) mit einem aktiven Bereich (233, 333) und einem integralen Linearpolarisator (205, 305), der über dem aktiven Bereich (233, 333) angeordnet ist;
einen Viertelwellenverzögerer (207, 307), der über dem integralen Linearpolarisator (205, 305) angeordnet ist; und
eine Linsenvorrichtung, umfassend:
eine Linse (236, 336), die im Wesentlichen mit dem Display (230, 330) ausgerichtet und außerhalb des Displays angeordnet ist, einen Linsenrand (237, 337, 437) mit einer Linsenrandfarbe, die mit einer Aktivbereichsfarbe des aktiven Bereichs (233, 333) der Display-Vorrichtung (200, 300, 400) im Wesentlichen übereinstimmt, wenn die Display-Vorrichtung (200, 300, 400) ausgeschaltet ist, und einen Zirkularpolarisator (201, 301), der nahe dem Linsenrand (237, 337, 437) zwischen der Linse (236, 336) und dem Viertelwellenverzögerer (207, 307) angeordnet ist, wobei der Zirkularpolarisator (201, 301) im Wesentlichen mit der Display-Vorrichtung (200, 300, 400) ausgerichtet ist;
wobei der Zirkularpolarisator (201, 301) dazu ausgelegt ist, Umgebungslicht, das in das Gerät eintritt, in einer ersten Richtung zirkular zu polarisieren und zu verhindern, dass Licht, das in einer der ersten Richtung entgegengesetzten zweiten Richtung zirkular polarisiert ist, durch den Zirkularpolarisator (201, 301) nach außen dringt, und wobei der Viertelwellenverzögerer (207, 307) dazu ausgelegt ist, Display-Licht, das von dem integralen Linearpolarisator (205, 305) emittiert wird, gemäß der ersten Richtung zirkular zu polarisieren.

2. Gerät nach Anspruch 1, wobei der aktive Bereich (233, 333) der Display-Vorrichtung (200, 300, 400) eine Aktivbereichsluminanz aufweist und der Linsenrand (237, 337, 437) eine Linsenrandluminanz aufweist, die im Wesentlichen mit der Aktivbereichsluminanz übereinstimmt.

3. Gerät nach Anspruch 1, wobei der Linsenrand (237, 337, 437) zwischen der Linse (236, 336) und dem Zirkularpolarisator (201, 301) angeordnet ist.

4. Gerät nach Anspruch 1, wobei der Linsenrand zwischen dem Zirkularpolarisator (201, 301) und dem Viertelwellenverzögerer (207, 307) angeordnet ist.

5. Gerät nach Anspruch 3, wobei der Zirkularpolarisator (301) an einer Innenfläche der Linse (336) befestigt ist oder mit der Innenfläche der Linse (336) einstückig ist und wobei der Linsenrand (437) an einer Innenfläche des Zirkularpolarisators (301) angeordnet ist.

6. Gerät nach Anspruch 3, wobei das Display (230, 330) einen Displayrand (232, 332) aufweist, der den aktiven Bereich (233, 333) der Display-Vorrichtung (200, 300, 400) definiert, und wobei das Gerät ferner ein Touchpanel (234, 334) umfasst, das zwischen dem Viertelwellenverzögerer (207, 307) und dem Zirkularpolarisator (201, 301) angeordnet ist.

7. Vorrichtung nach einem der Ansprüche 1 bis 6, wobei der Linsenrand (237, 337, 437) ein Siebdruckrand, ein Tintenrand oder ein bemalter Rand ist, der auf der Linse (236, 336) oder dem Zirkularpolarisator (201, 301) angeordnet ist, wobei das Display (230, 330) ein Flüssigkristall-Display, LCD, eine Leuchtdiode, LED, eine organische LED, OLED, eine Aktivmatrix-OLED, AMOLED, eine Kathodenstrahlröhre, CRT, ein Elektrolumineszenz-Display, eine Vakuum-Fluoreszenz-Display oder ein mikroelektromechanisches(MEM)-Display ist und wobei die Display-Vorrichtung (200, 300, 400) eine durchlässige Display-Vorrichtung oder eine emittierende Display-Vorrichtung ist.

8. Gerät nach Anspruch 1, wobei der Viertelwellenverzögerer ein integraler Viertelwellenverzögerer (207) des Displays (230) ist.

9. Gerät nach Anspruch 1, wobei der Viertelwellenverzögerer außerhalb des Displays (330) angeordnet ist.

10. Gerät nach Anspruch 1, wobei der Zirkularpolarisator (201, 301) einen zweiten Viertelwellenverzögerer (204, 304) und einen zweiten Linearpolarisator (202, 302) umfasst, der zwischen der Linse (236, 336) und dem zweiten Viertelwellenverzögerer (204, 304) angeordnet ist, wobei der zweite lineare Polarisator (202, 302) eine Lichtübertragungsachse (206, 306) definiert, durch die Licht durch den zweiten Linearpolarisator (202, 302) hindurchtreten kann, und wobei der integrale lineare Polarisator (205, 305) des Displays (230, 330) dazu ausgelegt ist, Displaylicht zu emittieren, das an einer Display-Übertragungsachse (208, 308) ausgerichtet ist, wobei die Display-Übertragungsachse (208, 308) im Wesentlichen an der Lichtübertragungsachse (206, 306) des zweiten Linearpolarisators (202, 302) ausgerichtet ist.

11. Mobile Vorrichtung, die ein Gerät nach einem der vorhergehenden Ansprüche umfasst.

12. Verfahren (500), umfassend:
Ermöglichen (502), dass Umgebungslicht in ein Gerät eintritt, wobei das Gerät umfasst:
eine Display-Vorrichtung (200, 300, 400) mit einem aktiven Bereich (233, 333) und einem integralen Linearpolarisator (205, 305), der über dem aktiven Bereich (233, 333) angeordnet ist;
einen Viertelwellenverzögerer (207, 307), der über dem integralen Linearpolarisator (205, 305) angeordnet ist; und
eine Linsenvorrichtung, umfassend:
eine Linse (236, 336), die im Wesentlichen mit dem Display (230, 330) ausgerichtet und außerhalb des Displays angeordnet ist; einen Linsenrand (237, 337, 437) mit einer Linsenrandfarbe, die mit einer Aktivbereichsfarbe des aktiven Bereichs (233, 333) der Display-Vorrichtung (200, 300, 400) übereinstimmt, wenn die Display-Vorrichtung (200, 300, 400) ausgeschaltet ist, und einen Zirkularpolarisator (201, 301), der nahe dem Linsenrand (237, 337, 437) zwischen der Linse (236, 336) und dem Viertelwellenverzögerer (207, 307) angeordnet ist, wobei der Zirkularpolarisator (201, 301) im Wesentlichen mit der Display-Vorrichtung (200, 300, 400) ausgerichtet ist;
Zirkularpolarisieren (504) des Umgebungslichts in einer ersten Richtung mit dem Zirkularpolarisator (201, 301);
Verhindern (506), dass reflektierte Teile des zirkular polarisierten Umgebungslichts durch den Zirkularpolarisator (201, 301) nach außen dringen;
zirkulares Polarisieren des vom integralen Linearpolarisator (205, 305) emittierten Display-Lichts gemäß der ersten Richtung mit dem Viertelwellenverzögerer (207, 307); und
Ermöglichen, dass das vom integralen Linearpolarisator (205, 305) emittierte zirkular polarisierte Licht durch den zirkularen Polarisator (201, 301) nach außen dringt.

13. Verfahren nach Anspruch 12, wobei das reflektierte Umgebungslicht in einer zweiten Richtung entgegengesetzt zu der ersten Richtung zirkular polarisiert wird und wobei der Linsenrand (237, 337, 437) zwischen der Linse (236, 336) und dem Zirkularpolarisator (201, 301) oder zwischen dem Zirkularpolarisator (201, 301) und dem Viertelwellenverzögerer (207, 307) angeordnet ist.

14. Verfahren nach Anspruch 12, wobei der Zirkularpolarisator (201, 301) zwischen der Linse (236, 336) und dem Linsenrand (237, 337, 437) angeordnet ist.

15. Verfahren nach Anspruch 12, wobei die Aktivbereichsfarbe und die Aktivbereichsluminanz im Wesentlichen mit der Linsenrandfarbe und der Linsenrandluminanz übereinstimmen, um dem Linsenrand (337) und dem aktiven Bereich (333) ein im Wesentlichen einheitliches Erscheinungsbild zu verleihen, wobei ein Touchpanel (234, 334) zwischen dem Viertelwellenverzögerer (207, 307) und dem Zirkularpolarisator (201, 301) angeordnet ist, und wobei die reflektierten Teile des zirkular polarisierten Umgebungslichts, die mit dem Zirkularpolarisator (201, 301) daran gehindert werden, durch die Linse (236, 336) nach außen zu dringen, Umgebungslicht umfassen, das vom Touchpanel (234, 334) reflektiert wird.

## Revendications

1. Appareil comprenant :
un dispositif d'affichage (200, 300, 400) ayant une zone active (233, 333) et un polariseur linéaire intégré (205, 305) situé sur la zone active (233, 333) ;
un retardateur quart d'onde (207, 307) situé sur le polariseur linéaire intégré (205, 305) ; et
un dispositif à lentille comprenant :
une lentille (236, 336) sensiblement alignée avec l'écran et située à l'extérieur de l'écran (230, 330),
une bordure de lentille (237, 337, 437) ayant une couleur de bordure de lentille correspondant sensiblement à une couleur de zone active de la zone active (233, 333) du dispositif d'affichage (200, 300, 400) lorsque le dispositif d'affichage (200, 300, 400) est éteint, et
un polariseur circulaire (201, 301) situé à proximité de la bordure de lentille (237, 337, 437) entre la lentille (236, 336) et le retardateur quart d'onde (207, 307), le polariseur circulaire (201, 301) étant sensiblement aligné avec le dispositif d'affichage (200, 300, 400) ;
le polariseur circulaire (201, 301) étant configuré pour polariser de manière circulaire, dans une première direction, de la lumière ambiante entrant dans l'appareil, et pour empêcher de la lumière, polarisée de manière circulaire dans une seconde direction opposée à la première direction, de passer vers l'extérieur à travers le polariseur circulaire (201, 301), et le retardateur quart d'onde (207, 307) étant configuré pour polariser de manière circulaire, selon ladite première direction, de la lumière d'affichage émise par le polariseur linéaire intégré (205, 305).

2. Appareil selon la revendication 1, dans lequel la zone active (233, 333) du dispositif d'affichage (200, 300, 400) a une luminance de zone active et la bordure de lentille (237, 337, 437) a une luminance de bordure de lentille qui correspond sensiblement à la luminance de zone active.

3. Appareil selon la revendication 1, dans lequel la bordure de lentille (237, 337, 437) est située entre la lentille (236, 336) et le polariseur circulaire (201, 301).

4. Appareil selon la revendication 1, dans lequel la bordure de lentille est située entre le polariseur circulaire (201, 301) et le retardateur quart d'onde (207, 307).

5. Appareil selon la revendication 3, dans lequel le polariseur circulaire (301) est fixé à une surface interne de la lentille (336) ou fait partie intégrante de la surface interne de la lentille (336), et la bordure de lentille (437) étant située sur une surface interne du polariseur circulaire (301).

6. Appareil selon la revendication 3, dans lequel l'affichage (230, 330) a une bordure d'affichage (232, 332) qui définit la zone active (233, 333) du dispositif d'affichage (200, 300, 400), et l'appareil comprenant en outre un écran tactile (234, 334) situé entre le retardateur quart d'onde (207, 307) et le polariseur circulaire (201, 301).

7. Appareil selon l'une quelconque des revendications 1 à 6, dans lequel la bordure de lentille (237, 337, 437) est une bordure sérigraphiée, une bordure encrée ou une bordure peinte située sur la lentille (236, 336) ou le polariseur circulaire (201, 301), l'affichage (230, 330) étant un affichage à cristaux liquides, LCD, une diode électroluminescente, DEL, une DEL organique, DELO, une DELO à matrice active, DELO à matrice active, un tube cathodique, CRT, un affichage électroluminescent, un affichage fluorescent sous vide ou un affichage micro-électromécanique MEM, et le dispositif d'affichage (200, 300, 400) étant un dispositif d'affichage transmissif ou un dispositif d'affichage émissif.

8. Appareil selon la revendication 1, dans lequel ledit retardateur quart d'onde est un retardateur quart d'onde intégré (207) de l'affichage (230).

9. Appareil selon la revendication 1, dans lequel ledit retardateur quart d'onde est situé à l'extérieur de l'affichage (330).

10. Appareil selon la revendication 1, dans lequel ledit polariseur circulaire (201, 301) comprend un second retardateur quart d'onde (204, 304) et un second polariseur linéaire (202, 302) situé entre ladite lentille (236, 336) et le second retardateur quart d'onde (204, 304), le second polariseur linéaire (202, 302) définissant un axe de transmission de lumière (206, 306) permettant à de la lumière de passer à travers le second polariseur linéaire (202, 302), et le polariseur linéaire intégré (205, 305) de l'affichage (230, 330) étant configuré pour émettre de la lumière d'affichage alignée avec un axe de transmission d'affichage (208, 308), l'axe de transmission d'affichage (208, 308) étant sensiblement aligné avec l'axe de transmission de lumière (206, 306) du second polariseur linéaire (202, 302).

11. Dispositif mobile comprenant un appareil selon l'une quelconque des revendications précédentes.

12. Procédé (500) comprenant :
le fait de permettre (502) à de la lumière ambiante de pénétrer dans un appareil, l'appareil comprenant :
un dispositif d'affichage (200, 300, 400) ayant une zone active (233, 333) et un polariseur linéaire intégré (205, 305) situé sur la zone active (233, 333) ;
un retardateur quart d'onde (207, 307) situé sur le polariseur linéaire intégré (205, 305) ; et
un dispositif à lentille comprenant :
une lentille (236, 336) sensiblement alignée avec l'écran et située à l'extérieur de l'écran (230, 330), une bordure de lentille (237, 337, 437) ayant une couleur de bordure de lentille correspondant à une couleur de zone active de la zone active (233, 333) du dispositif d'affichage (200, 300, 400) lorsque le dispositif d'affichage (200, 300, 400) est éteint, et un polariseur circulaire (201, 301) situé à proximité de la bordure de lentille (237, 337, 437) entre la lentille (236, 336) et le retardateur quart d'onde (207, 307), le polariseur circulaire (201, 301) étant sensiblement aligné avec le dispositif d'affichage (200, 300, 400) ;
la polarisation de manière circulaire (504), dans une première direction, de la lumière ambiante à l'aide du polariseur circulaire (201, 301) ;
le fait d'empêcher (506) les parties réfléchies de la lumière ambiante polarisée de manière circulaire de passer vers l'extérieur à travers le polariseur circulaire (201, 301) ;
la polarisation de manière circulaire, selon ladite première direction, de lumière d'affichage émise par le polariseur linéaire intégré (205, 305) avec le retardateur quart d'onde (207, 307) ; et
le fait de permettre à la lumière polarisée de manière circulaire émise par le polariseur linéaire intégré (205, 305) de passer vers l'extérieur à travers le polariseur circulaire (201, 301).

13. Procédé selon la revendication 12, dans lequel la lumière ambiante réfléchie est polarisée de manière circulaire dans une seconde direction opposée à ladite première direction, et la bordure de lentille (237, 337, 437) étant située entre la lentille (236, 336) et le polariseur circulaire (201, 301) ou entre le polariseur circulaire (201, 301) et le retardateur quart d'onde (207, 307).

14. Procédé selon la revendication 12, dans lequel le polariseur circulaire (201, 301) est situé entre la lentille (236, 336) et la bordure de lentille (237, 337, 437).

15. Procédé selon la revendication 12, dans lequel la couleur de zone active et la luminance de zone active correspondent sensiblement à la couleur de bordure de lentille et à la luminance de bordure de lentille pour donner à la bordure de lentille (337) et à la zone active (333) une apparence sensiblement uniforme, un écran tactile (234, 334) étant situé entre le retardateur quart d'onde (207, 307) et le polariseur circulaire (201, 301), et lesdites parties réfléchies de la lumière ambiante polarisée de manière circulaire qui sont empêchées de passer vers l'extérieur à travers la lentille (236, 336) à l'aide du polariseur circulaire (201, 301) comprenant de la lumière ambiante réfléchie par l'écran tactile (234, 334).
